(19) Europäisches Patentamt
European Patent Office
Office européen des brevets

(11) **EP 4 123 685 B1**

(12) **EUROPEAN PATENT SPECIFICATION**

(45) Date of publication and mention
of the grant of the patent:
**18.09.2024 Bulletin 2024/38**

(21) Application number: **22183898.0**

(22) Date of filing: **08.07.2022**

(51) International Patent Classification (IPC):
**B23K 26/073** *(2006.01)*     **B23K 26/082** *(2014.01)*
**B23K 26/352** *(2014.01)*     **H01L 21/02** *(2006.01)*

(52) Cooperative Patent Classification (CPC):
**B23K 26/082; B23K 26/0732; B23K 26/352;**
B23K 2103/56; H01L 21/02678; H01L 21/02686;
H01L 21/02691

(54) **CONTROL DEVICE OF ANNEALING DEVICE, ANNEALING DEVICE, AND ANNEALING METHOD**

STEUERVORRICHTUNG EINER GLÜHVORRICHTUNG, GLÜHVORRICHTUNG UND
GLÜHVERFAHREN

DISPOSITIF DE COMMANDE D'UN DISPOSITIF DE RECUIT, DISPOSITIF DE RECUIT ET
PROCÉDÉ DE RECUIT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.07.2021 JP 2021115132**

(43) Date of publication of application:
**25.01.2023 Bulletin 2023/04**

(73) Proprietor: **Sumitomo Heavy Industries, Ltd.
Tokyo 141-6025 (JP)**

(72) Inventors:
• **OKADA, Yasuhiro
Kanagawa, 237-8555 (JP)**
• **YOROZU, Masafumi
Kanagawa, 237-8555 (JP)**

(74) Representative: **Becker, Eberhard
Becker Kurig & Partner
Patentanwälte mbB
Bavariastraße 7
80336 München (DE)**

(56) References cited:
CN-A- 112 864 040     US-A1- 2004 140 297
US-A1- 2005 237 895     US-A1- 2011 049 764

**Description**

BACKGROUND

Technical Field

The disclosure relates to a control device of an annealing device, an annealing device, and an annealing method.

Description of Related Art

In order to activate a dopant doped in a flat plate-shaped annealed target such as a silicon wafer, it is necessary to heat (anneal) the annealed target. In the process of manufacturing an insulated gate bipolar transistor (IGBT) or the like, a circuit element is formed on one surface of a semiconductor wafer, and then an impurity is doped on the other surface to perform annealing. When annealing is performed, a protective tape made of resin is attached to the circuit forming surface. In order to prevent the protective tape from melting, it is desired to suppress the temperature of the circuit forming surface from rising.

In order to sufficiently heat the surface opposite to the circuit forming surface and suppress the temperature of the circuit forming surface from rising, laser annealing has been used to irradiate the surface opposite to the circuit forming surface with a laser light (see, for example, Patent Literature 1, etc.). In the annealing technique described in Patent Literature 1, after one laser pulse is incident, a laser pulse of the next cycle is incident on a portion in the cooling process after the temperature rise. As a result, the energy of the laser pulse can be effectively utilized, and therefore the amount of energy to be input to the semiconductor wafer is reduced. By reducing the amount of energy input, it is possible to suppress the temperature of the surface opposite to the laser irradiation surface from rising.

Related Art

Patent Literature

[Patent Literature 1] Japanese Patent Laid-Open No. 2020-202242
Document CN 112 864 040 discloses the preamble of claims 1 and 4.

SUMMARY

Problems to be Solved

If the annealed target such as a semiconductor wafer is thin, the temperature of the surface opposite to the laser irradiation surface tends to rise. An object of the disclosure is to provide a control device of an annealing device, an annealing device, and an annealing method which are capable of further suppressing the temperature of the surface opposite to the laser irradiation surface from rising.

Means for Solving the Problems

According to one aspect of the disclosure, an annealing device according to claim 1 is provided.
According to another aspect of the disclosure, an annealing method according to claim 4 is provided.

Effects

By sweeping the beam spot in the longitudinal direction of the beam spot, it is possible to suppress the temperature of the surface opposite to the laser irradiation surface of the annealed target from rising under the same condition of pulse energy density.

BRIEF DESCRIPTION OF THE DRAWINGS

FIG. 1 is a schematic perspective view of the annealing device according to an embodiment.
FIG. 2 is a schematic view of the laser annealing device according to the present embodiment.
FIG. 3 is a graph showing the calculated value of the temporal change of the surface temperature T when one shot of the pulsed laser beam is incident on the silicon wafer.
FIG. 4 is a cross-sectional view of the annealed target on which the pulsed laser beam is incident.
FIG. 5A and FIG. 5B are graphs showing an example of the calculation result of the temperature distribution in the cross section of the annealed target.
FIG. 6 is a flowchart showing the procedure of the annealing method according to an embodiment.
FIG. 7A and FIG. 7B are schematic views showing the trajectory of the beam spot when annealing is performed by the annealing methods according to an embodiment and a comparative example, respectively.
FIG. 8 is a graph showing the relationship between the sweep speed of the beam spot and the activation rate, and the relationship between the sweep speed of the beam spot and the reached maximum temperature of the back surface of the annealed target.
FIG. 9 is a graph showing the relationship between the aspect ratio of the beam spot, the reached maximum temperature of the back surface of the annealed target, and the activation rate.
FIG. 10 is a graph showing the relationship between the sweep speed when the aspect ratio of the beam spot is 1, the reached maximum temperature of the back surface of the annealed target, and the activation rate.

DESCRIPTION OF THE EMBODIMENTS

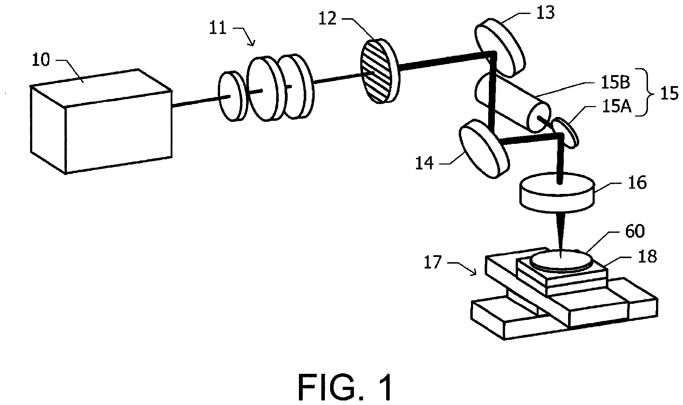

An annealing device and an annealing method according to an embodiment will be described with reference to FIG. 1 to FIG. 10.

FIG. 1 is a schematic perspective view of the annealing device according to an embodiment. A laser light source 10 outputs a pulsed laser beam. The pulsed laser beam output from the laser light source 10 passes through a beam expander 11, a beam shaping optical element 12, reflective mirrors 13 and 14, a beam scanner 15, and an fθ lens 16 to be incident on the laser irradiation surface of an annealed target 60. The annealed target 60 is, for example, a semiconductor wafer in which a dopant is ion-implanted.

The annealed target 60 is held by a chuck mechanism 18 supported by a movable stage 17. The movable stage 17 moves the chuck mechanism 18 in two directions in a horizontal plane. The movement of the chuck mechanism 18 causes the annealed target 60 to move. An XY stage, for example, is used as the movable stage 17.

The beam expander 11 adjusts the beam size (diameter of the beam cross section) at the incident position of the laser beam on the beam shaping optical element 12. The beam shaping optical element 12 shapes the beam spot on the beam irradiation surface of the annealed target 60 into a long shape in one direction and makes the intensity distribution uniform. A diffractive optical element, for example, is used as the beam shaping optical element 12. The beam scanner 15 includes a galvano mirror 15A and a motor 15B. The motor 15B rotates the galvano mirror 15A within a range in the tilting direction to scan the pulsed laser beam in one-dimensional direction. By this scanning, the beam spot moves in the longitudinal direction thereof on the surface of the annealed target 60. The fθ lens 16 concentrates the pulsed laser beam scanned by the beam scanner 15 on the laser irradiation surface of the annealed target 60.

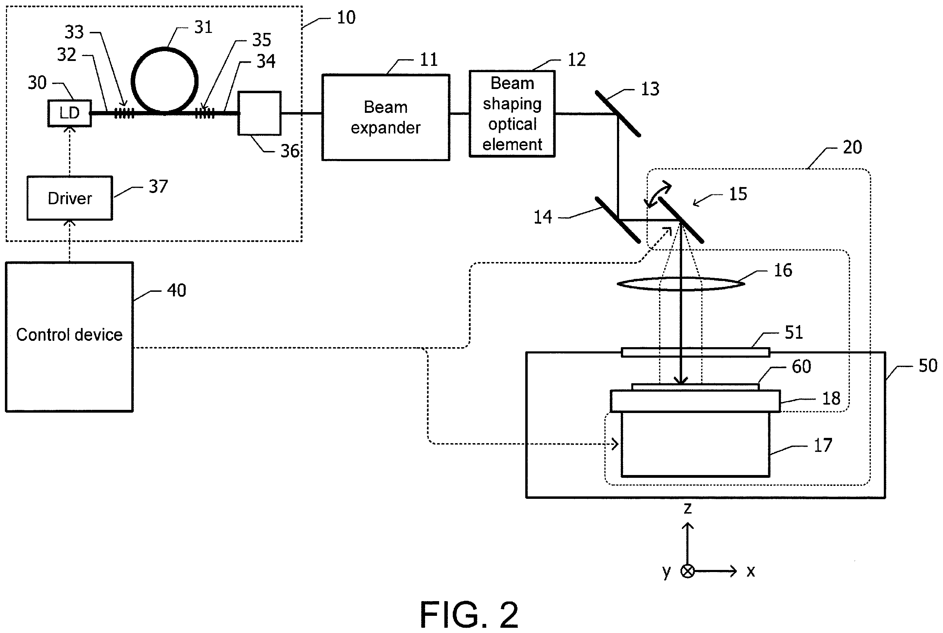

FIG. 2 is a schematic view of a laser annealing device according to the present embodiment. The description of the contents overlapping with the description of FIG. 1 will be omitted.

A fiber laser oscillator is used as the laser light source 10. An input side optical fiber 32 is connected to one end of a gain fiber 31 doped with a laser active medium, and an output side optical fiber 34 is connected to the other end. A high reflectance type fiber Bragg grating 33 is formed on the input side optical fiber 32, and a low reflectance type fiber Bragg grating 35 is formed on the output side optical fiber 34. An optical resonator is constituted by the high reflectance type fiber Bragg grating 33 and the low reflectance type fiber Bragg grating 35.

An excitation light output from a laser diode 30 is introduced into the gain fiber 31 through the input side optical fiber 32. The laser active medium doped in the gain fiber 31 is excited by the excitation light. Induced emission occurs when the laser active medium transitions to a low energy state, and a laser light is generated. The laser light generated by the gain fiber 31 passes through the output side optical fiber 34 and is incident on a wavelength conversion element 36. The laser beam wavelength-converted by the wavelength conversion element 36 passes through the beam expander 11, the beam shaping optical element 12, the reflective mirrors 13 and 14, the beam scanner 15, and the fθ lens 16 to be incident on the annealed target 60. The gain fiber 31 outputs, for example, a laser light in an infrared region, and the wavelength conversion element 36 converts the laser light in the infrared region into a laser light in a green wavelength region.

A driver 37 drives the laser diode 30 based on a command from a control device 40. The command received from the control device 40 includes information that specifies the repetition frequency of the laser pulse output from the laser diode 30. The driver 37 outputs the excitation laser light from the laser diode 30 at the repetition frequency of the laser pulse commanded by the control device 40. As a result, the pulsed laser beam is output from the laser light source 10 at the commanded repetition frequency.

The movable stage 17 and the chuck mechanism 18 are arranged in a chamber 50. A laser transmission window 51 is attached to a wall surface of the chamber 50 above the annealed target 60 held by the chuck mechanism 18. The pulsed laser beam transmitted through the fθ lens 16 passes through the laser transmission window 51 and is incident on the laser irradiation surface of the annealed target 60. The laser annealing device according to the present embodiment performs activation annealing on the dopant doped in the annealed target 60, for example. The annealed target 60 is, for example, a silicon wafer.

The control device 40 includes a console to be operated by a user. The user operates the console to input information that specifies the repetition frequency of the pulse of the pulsed laser beam. The control device 40 gives the driver 37 the information that specifies the repetition frequency of the input pulse.

The control device 40 further controls the beam scanner 15 and the movable stage 17 to move the beam spot on the laser irradiation surface of the annealed target 60. By scanning the pulsed laser beam with the beam scanner 15, an xyz orthogonal coordinate system is defined in which the direction in which the beam spot moves is an x direction and the direction orthogonal to the x direction in the laser irradiation surface is a y direction. The beam spot of the pulsed laser beam has a long shape in the x direction.

The operation of operating the beam scanner 15 to move the beam spot in the x direction is referred to as a "sweep operation." When the control device 40 controls the movable stage 17 to move the annealed target 60 in the y direction, the position of the beam spot is displaced in the y direction (shifted in the y direction) on the surface of the annealed target 60. The operation of displacing the position of the beam spot in the y direction is referred to as a "step operation."

By driving either the beam scanner 15 or the movable stage 17 in this way, the beam spot can be moved in the x direction or the y direction on the surface of the annealed target 60. The beam scanner 15 and the movable stage 17 constitute a movement mechanism 20 that moves the beam spot in a two-dimensional direction on the surface of the annealed target 60.

The maximum length by which the beam spot can be swept in the x direction depends on the swing angle of the pulsed laser beam of the beam scanner 15 and the performance of the fθ lens 16. If the maximum length of the sweep is shorter than the dimensions of the annealed target 60, almost the entire area of the annealed target 60 can be annealed by repeating the sweep operation and the step operation and executing a plurality of times the procedure of annealing in a part of the range in the x direction by shifting the annealed target 60 in the x direction.

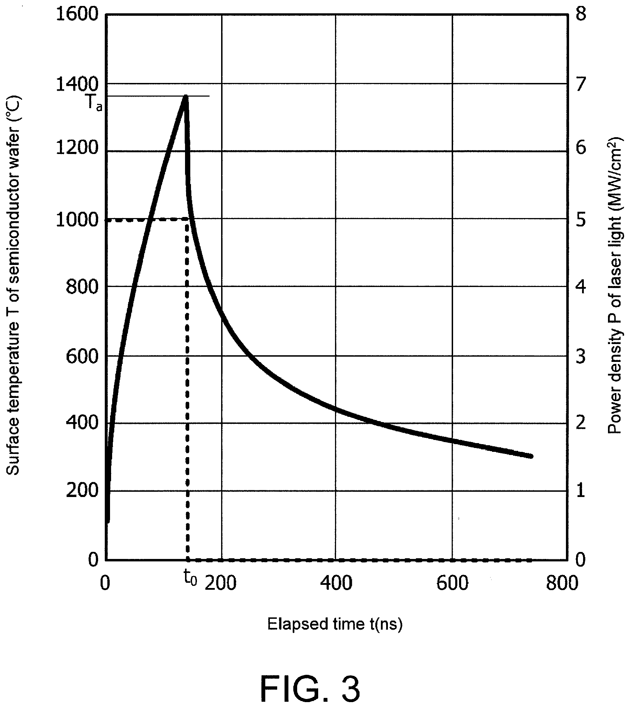

Next, a temporal change of the surface temperature when the pulsed laser beam is incident on the annealed target 60 will be described with reference to FIG. 3.

For simplicity, a case where a laser pulse having a uniform power density P is incident on the annealed target 60 will be described. The surface temperature T of the laser irradiation surface of the annealed target 60 can be expressed by the following equation.
[Equation 1]

$$T = 2P\sqrt{\frac{t}{\pi C \rho \lambda}} \cdots (1)$$

Here, t is the elapsed time from the start of heating, C is the specific heat of the annealed target 60, $\rho$ is the density of the annealed target 60, and $\lambda$ is the thermal conductivity of the annealed target 60. For example, the unit of the surface temperature T is "K," the unit of the power density P is "W/cm$^2$," the unit of the elapsed time t is "second," the unit of the specific heat C is "J/g·K," the unit of the density $\rho$ is "g/cm$^3$," and the unit of the thermal conductivity $\lambda$ is "W/cm-K."

When the pulse width of the pulsed laser beam is marked as $t_0$, the reached maximum temperature $T_a$ of the laser irradiation surface is expressed by the following equation.
[Equation 2]

$$T_a = 2P\sqrt{\frac{t_0}{\pi C \rho \lambda}} \cdots (2)$$

When the target value of the reached maximum temperature $T_a$ of the laser irradiation surface is determined, the power density P and the pulse width $t_0$ required to raise the temperature to the target value are determined.

FIG. 3 is a graph showing the calculated value of the temporal change of the surface temperature T when one shot of the pulsed laser beam is incident on the silicon wafer. The horizontal axis represents the elapsed time t from the rising point of the laser pulse in the unit "ns," the left vertical axis represents the surface temperature T of the annealed target 60 in the unit "°C," and the right vertical axis represents the power density P of the pulsed laser beam in the unit "MW/cm$^2$." The broken line in the graph shows the temporal change of the power density P of the pulsed laser beam, and the solid line shows the temporal change of the surface temperature T of the annealed target 60. The pulse width of the pulsed laser beam is $t_0$, and the peak power density is 5 MW/cm$^2$.

During the period ($0 \leq t \leq t_0$) in which the laser pulse is incident, the surface temperature T rises according to Equation (1). The surface temperature T at the point ($t = t_0$) when the time corresponding to the pulse width $t_0$ elapses from the rising point of the laser pulse is equal to the reached maximum temperature $T_a$. After the laser pulse falls ($t \geq t_0$), the surface temperature T gradually decreases.

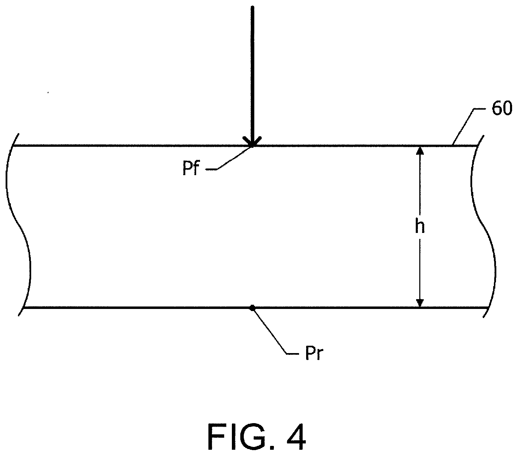

Next, the temperature rise of the surface (hereinafter referred to as a back surface) opposite to the laser irradiation surface of the annealed target 60 will be described with reference to FIG. 4 to FIG. 5B.

FIG. 4 is a cross-sectional view of the annealed target 60 on which the pulsed laser beam is incident. The incident position of the laser beam is a heat source Pf. For simplicity, considering the temperature distribution directly under the heat source of an infinitely thick plate, the temperature rise amount ΔT of the position Pr on the back surface directly under the heat source Pf is expressed by the following equation.
[Equation 3]

$$\Delta T = \frac{Q}{2\pi \lambda h} e^{-\frac{vh}{2k}} \cdots (3)$$

Here, Q is the heat input from the heat source Pf to the annealed target 60, h is the thickness of the annealed target 60, v is the sweep speed of the heat source Pf, and k is the thermal diffusivity of the annealed target 60. For example, the unit of the input heat Q is "W," the unit of the thickness h of the annealed target 60 is "cm," the unit of the sweep speed v is "cm/s," and the unit of the thermal diffusivity k is "cm$^2$/s."

From Equation (3), it can be seen that the slower the sweep speed v of the heat source Pf, the larger the temperature rise amount ΔT of the point Pr on the back surface. In particular, when the thickness h of the annealed target 60 is thin, the increase in the temperature rise amount ΔT becomes remarkable.

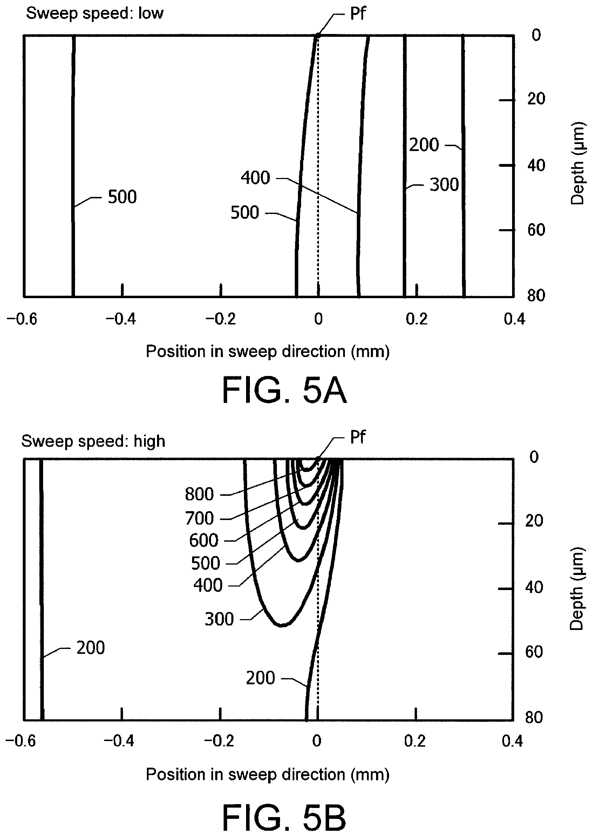

FIG. 5A and FIG. 5B are graphs showing an example of the calculation result of the temperature distribution in the cross section of the annealed target 60. FIG. 5A and FIG. 5B show the temperature distribution in the cross section of the annealed target 60 under the conditions of a finite thickness and the back surface being adiabatic. The horizontal axis represents the position of the heat source Pf in the sweep direction. The current position of the heat source Pf is defined as the origin of the horizontal axis, and the movement direction of the heat source is defined as positive. The vertical axis represents the depth from the beam irradiation surface in the unit "μm." FIG. 5A and FIG. 5B show the temperature distribution when the sweep speed v of the heat source Pf is different. FIG. 5B shows the temperature distribution when the sweep speed v of the heat source Pf is faster than that of FIG. 5A. The curves in the graph represent isotherms, and the numerical values attached to the curves represent the temperatures in the unit "°C."

It can be seen that when the sweep speed v is slow (FIG. 5A), the temperature gradient in the thickness direction is gentler than when the sweep speed v is fast (FIG. 5B). That is, when the sweep speed v is slow, the temperature rise amount ΔT of the back surface is larger than when the sweep speed v is fast. In other words, by increasing the sweep speed v, the temperature rise amount ΔT of the back surface can be reduced.

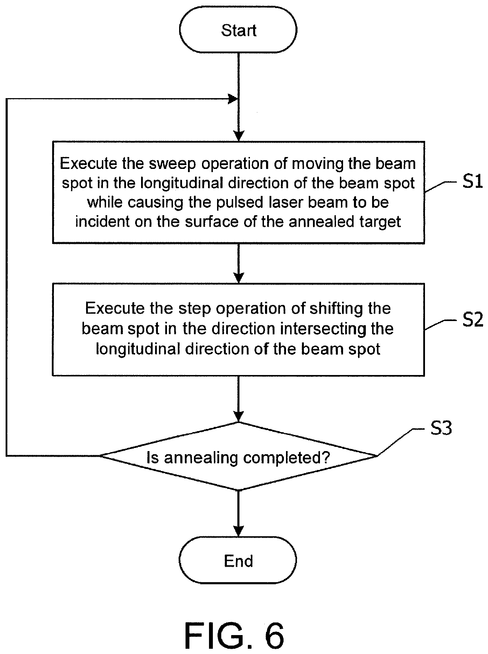

Next, an annealing method according to an embodiment will be described with reference to FIG. 6. FIG. 6 is a flowchart showing the procedure of the annealing method according to the embodiment. First, the control device 40 (FIG. 1 and FIG. 2) controls the laser light source 10 and the beam scanner 15 to execute the sweep operation of moving the beam spot in the longitudinal direction thereof while causing the pulsed laser beam to be incident on the annealed target 60 (step S1).

When one sweep operation is completed, the control device 40 controls the movable stage 17 to execute the step operation of shifting the annealed target 60 in the direction intersecting the longitudinal direction of the beam spot (step S2). The sweep operation of step S1 and the step operation of step S2 are repeated until almost the entire area of the surface of the annealed target 60 is annealed (step S3).

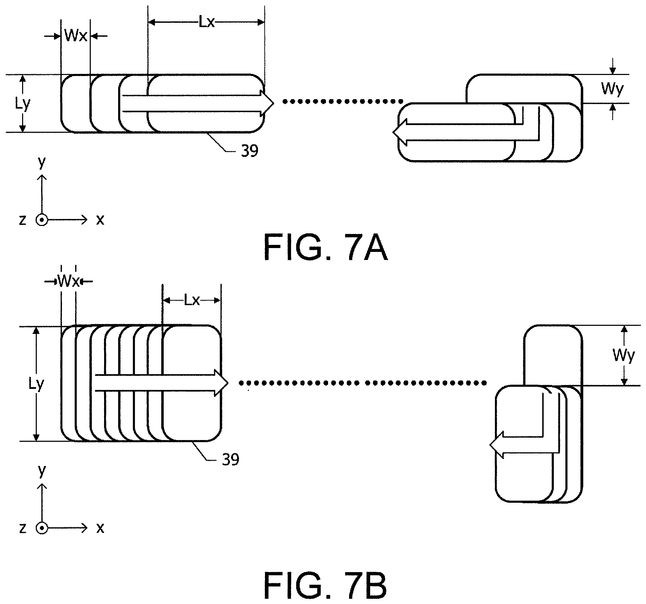

Next, with reference to FIG. 7A and FIG. 7B, the excellent effects of the embodiment will be described in comparison with a comparative example. FIG. 7A and FIG. 7B are schematic views showing the trajectory of the beam spot 39 when annealing is performed by the annealing methods according to the embodiment and the comparative example, respectively. The white arrows in FIG. 7A and FIG. 7B indicate the direction of movement of the beam spot 39 with respect to the annealed target 60.

In both the embodiment and the comparative example, the sweep direction of the beam spot 39 is parallel to the x direction. The sweep of the beam spot 39 is performed by operating the beam scanner 15 (FIG. 1 and FIG. 2). When one sweep is completed, the step operation of shifting the beam spot 39 in the y direction is performed. The annealing is performed by alternately repeating the sweep operation and the step operation.

The dimension of the beam spot 39 in the x direction is marked as Lx, and the dimension in the y direction is marked as Ly. The distance by which the beam spot 39 moves in the x direction during one cycle of the pulsed laser beam is marked as Wx. The distance by which the beam spot 39 moves in the y direction in one step operation is marked as Wy. The overlap rate OVx in the x direction and the overlap rate OVy in the y direction are expressed by the following equations.

[Equation 4]

$$OVx = \frac{Lx - Wx}{Lx}$$

$$OVy = \frac{Ly - Wy}{Ly} \cdots (4)$$

In the embodiment, the dimension Lx of the beam spot 39 in the x direction is larger than the dimension Ly in the y direction. In the embodiment, the beam spot 39 is swept in the longitudinal direction thereof. In contrast, in the comparative example, the dimension Ly in the y direction is larger than the dimension Lx in the x direction. In the comparative example, the beam spot 39 is swept in a direction orthogonal to the longitudinal direction thereof.

The case where the dimension Lx in the x direction and the dimension Ly in the y direction of the beam spot 39 according to the embodiment are respectively equal to the dimension Ly in the y direction and the dimension Lx in the x direction of the beam spot 39 according to the comparative example is considered. That is, the beam spot 39 according to the embodiment and the beam spot 39 according to the comparative example have the same size and shape. Further, the overlap rates OVx in the x direction and the overlap rates OVy in the y direction are the same in the embodiment and the comparative example.

Under this condition, the numbers of shots required to anneal almost the entire area of the annealed target 60 are substantially the same in the embodiment and the comparative example. Further, the pulse energy densities are the same in the embodiment and the comparative example. Therefore, as shown in FIG. 3, the reached maximum temperatures of the surface of the annealed target 60 are also substantially the same in the embodiment and the comparative example. Therefore, when activation annealing of the annealed target 60 is performed, the activation rates are also substantially the same.

Since the sizes of the beam spot 39 and the overlap rates OVx in the x direction are the same in the embodiment and the comparative example, the sweep speed of the beam spot 39 is faster in the embodiment than in the comparative example. Therefore, as described with reference to FIG. 5A and FIG. 5B, the reached maximum temperature of the back surface of the annealed target 60 is lower in the embodiment than in the comparative example. When annealing is performed under the condition of similar numbers of shots of the pulsed laser beam and similar activation rates, the present embodiment can suppress the temperature of the back surface of the annealed target 60 from rising as compared with the comparative example.

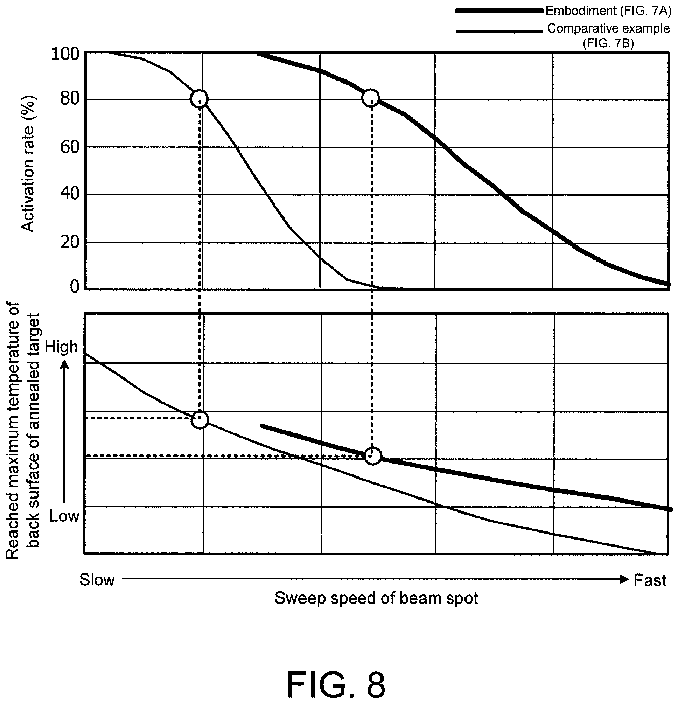

In order to confirm the excellent effects of the present embodiment, the sweep speed of the beam spot 39, the activation rate, and the reached maximum temperature of the back surface of the annealed target 60 were obtained by calculation. Hereinafter, the calculation result will be described with reference to FIG. 8.

FIG. 8 is a graph showing the relationship between the sweep speed of the beam spot 39 and the activation rate, and the relationship between the sweep speed of the beam spot 39 and the reached maximum temperature of the back surface of the annealed target 60. The horizontal axis represents the sweep speed of the beam spot, the vertical axis of the upper graph represents the activation rate in the unit "%," and the vertical axis of the lower graph represents the reached maximum temperature of the back surface of the annealed target 60. The thick solid line and the thin solid line in the graph show the calculation result when annealing was performed by the methods according to the embodiment (FIG. 7A) and the comparative example (FIG. 7B), respectively.

In the embodiment, the dimension Lx of the beam spot 39 in the x direction was double the dimension Ly in the y direction, and in the comparative example, the dimension Ly of the beam spot 39 in the y direction was double the dimension Lx in the x direction. Moreover, the repetition frequencies of the pulse and the pulse energy densities were set to be the same in the embodiment and the comparative example. In both the embodiment and the comparative example, the activation rate decreases as the sweep speed of the beam spot 39 increases, and the reached maximum temperature of the back surface of the annealed target 60 also decreases.

It can be seen that, when the beam spot 39 is swept under the condition that the activation rate is 80%, the reached maximum temperature of the back surface of the annealed target 60 is lower when the annealing method according to the embodiment is adopted than when the annealing method according to the comparative example is adopted. As described above, by adopting the annealing method according to the present embodiment, it is possible to achieve the desired activation rate while keeping the reached maximum temperature of the back surface low.

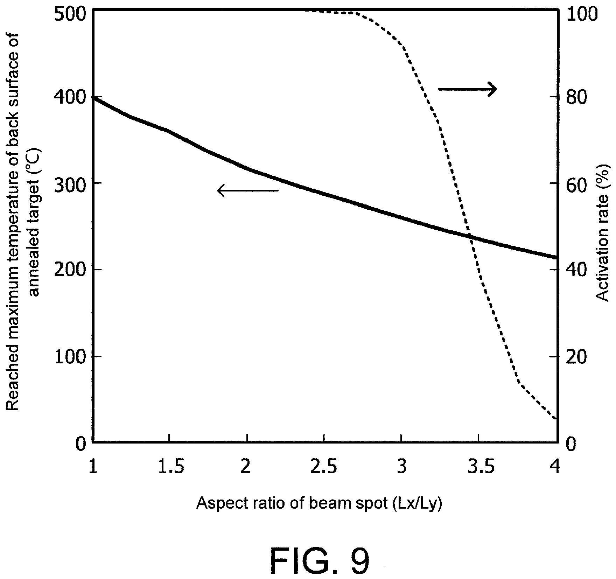

Next, a preferred shape of the beam spot 39 (FIG. 7A) will be described with reference to FIG. 9. FIG. 9 is a graph showing the relationship between the aspect ratio of the beam spot 39, the reached maximum temperature of the back surface of the annealed target 60, and the activation rate. Here, the aspect ratio is defined as the ratio of the dimension Lx in the x direction to the dimension Ly in the y direction of the beam spot 39. The horizontal axis of the graph shown in FIG. 9 represents the aspect ratio, the left vertical axis represents the reached maximum temperature of the back surface of the annealed target 60 in the unit "°C," and the right vertical axis represents the activation rate in the unit "%." The solid line in the graph shown in FIG. 9 indicates the reached maximum temperature of the back surface of the annealed target 60, and the broken line indicates the activation rate.

The graph shown in FIG. 9 was obtained by calculation. As the preconditions for the calculation, the annealed target 60 was a silicon wafer having a thickness of 50 $\mu$m, and the repetition frequency of the pulse of the pulsed laser beam was set to 800 kHz. Phosphorus ions were used as the dopant, and the acceleration energy at the time of ion implantation was set to 2.5 MeV. Even though the aspect ratio of the beam spot 39 was changed, the area of the beam spot 39 and the overlap rate OVx (Equation (4)) in the sweep direction were kept constant.

As the aspect ratio increases, the reached maximum temperature of the back surface of the annealed target 60 gradually decreases. This is because the sweep speed becomes faster. The activation rate drops sharply at the point when the aspect ratio exceeds about 3. The aspect ratio of the beam spot 39 is preferably smaller than the aspect ratio at the point when the activation rate starts to drop sharply. In accordance with the invention, the aspect ratio is 2.5 or less.

In addition, compared with the case where the aspect ratio is 1, that is, the beam spot 39 is square, in order to sufficiently achieve the effect of suppressing the rise of the reached maximum temperature of the back surface of the annealed target 60, the aspect ratio is set to 1.5 or more.

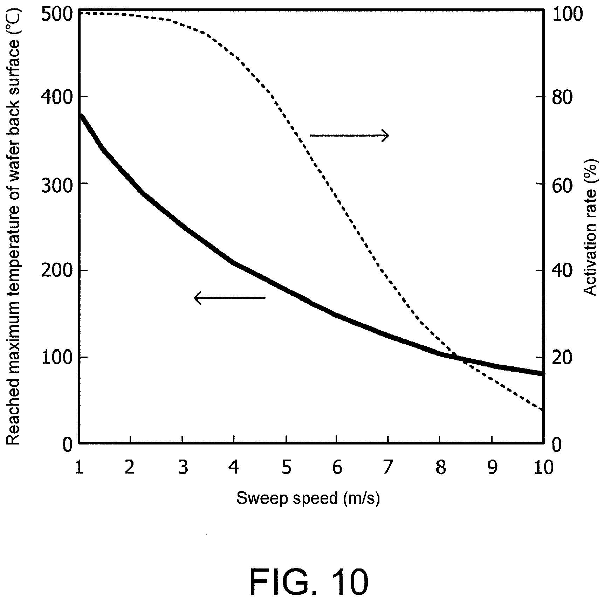

Next, the relationship between the sweep speed of the beam spot 39, the reached maximum temperature of the back surface of the annealed target 60, and the activation rate will be described with reference to FIG. 10. FIG. 10 is a graph showing the relationship between the sweep speed when the aspect ratio of the beam spot 39 is 1, the reached maximum temperature of the back surface of the annealed target 60, and the activation rate. The horizontal axis of the graph shown in FIG. 10 represents the sweep speed in the unit [m/s], the left vertical axis represents the reached maximum temperature of the back surface of the annealed target 60 in the unit "°C," and the right vertical axis represents the activation rate in the unit "%." The solid line in the graph shown in FIG. 10 indicates the reached maximum temperature of the back surface of the annealed target 60, and the broken line indicates the activation rate.

As the sweep speed increases, the reached maximum temperature of the back surface of the annealed target 60 decreases, and the activation rate also decreases. In the example shown in FIG. 10, when the allowable upper limit of the reached maximum temperature of the back surface of the annealed target 60 is 200 °C, the sweep speed has to be 4 m/s or more. From the calculation result shown in FIG. 9, it can be seen that, when the aspect ratio is increased from 1 to 2.5, the reached maximum temperature of the back surface of the annealed target 60 decreases by about 100 °C. Also, in the example shown in FIG. 10, when the aspect ratio of the beam spot 39 is set to about 2.5, the reached maximum temperature of the back surface is expected to decrease by about 100 °C. Then, even if the sweep speed is reduced to 2 m/s, the reached maximum temperature of the back surface can be suppressed to about 200 °C.

By optimizing the aspect ratio of the beam spot 39 in this way, the selectable range of the sweep speed can be expanded. In the above embodiment, the beam spot 39 (FIG. 7A) is swept in the x direction by operating the beam scanner 15 (FIG. 2). Therefore, it is possible to increase the sweep speed as compared with the case where the movable stage 17 is operated to move the annealed target 60 in the x direction for sweeping.

In order to reduce the temperature rise amount $\Delta T$ of the back surface of the annealed target 60, it is preferable to increase the sweep speed v as much as possible, as can be seen from Equation (3). However, if the sweep speed v is increased under the condition that the repetition frequency of the pulse of the pulsed laser beam and the dimension Lx of the beam spot 39 (FIG. 7A) in the x direction are constant, the overlap rate OVx in the x direction may become small or there may be no overlap.

If the dimension Lx of the beam spot 39 in the x direction is increased in order to maintain the overlap rate OVx when the sweep speed v is increased, the power density P on the surface of the annealed target 60 may be lowered. In order to maintain the reached maximum temperature $T_a$ of the laser irradiation surface under the condition of a low power density P, the pulse width $t_0$ has to be lengthened. If the pulse width $t_0$ is lengthened, the amount of heat transfer conducted in the thickness direction during the period in which the laser pulse is incident increases. As a result, the temperature of the irradiated surface becomes high. Accordingly, the dimension Lx cannot be increased unconditionally.

In order to maintain a sufficient overlap rate OVx without increasing the dimension Lx, the repetition frequency f of the pulse may be increased. For example, in order to suppress an excessive rise of the temperature of the back surface of the semiconductor wafer having a thickness of 100 $\mu$m or less, the repetition frequency f of the pulse is preferably set to 15 kHz or more, more preferably 100 kHz or more.

The above-described embodiment is an example, and the disclosure is not limited to the above-described embodiment. For example, it will be apparent to those skilled in the art that various changes, improvements, combinations are covered by the claims.

Reference Signs List

10 Laser light source
11 Beam expander
12 Beam shaping optical element
13, 14 Reflective mirror
15 Beam scanner
15A Galvano mirror
15B Motor
16 f$\theta$ lens
17 Movable stage
18 Chuck mechanism
20 Movement mechanism
30 Laser diode
31 Gain fiber
32 Input side optical fiber
33 Fiber Bragg grating
34 Output side optical fiber
35 Fiber Bragg grating
36 Wavelength conversion element
37 Driver
39 Beam spot
40 Control device
50 Chamber
51 Laser transmission window
60 Annealed target

## Claims

1. An annealing device, comprising:

   a laser light source (10) that outputs a pulsed laser beam;
   a beam shaping optical element (12) that shapes a beam spot (39) of the pulsed laser beam output from the laser light source on a surface of an annealed target (60) into an elongated shape
   a movement mechanism (20) that scans the pulsed laser beam and moves the beam spot in a longitudinal direction of the beam spot; and
   a control device (40) that controls the laser light source and the movement mechanism,
   wherein the control device performs annealing by performing a sweep operation of moving the beam spot in the longitudinal direction of the beam spot with respect to the annealed target while causing the pulsed laser beam to be incident on the annealed target, **characterized in that** an aspect ratio of the shaped elongated beam spot (39) is within a range of 1.5 to 2.5.

2. The annealing device according to claim 1, wherein the movement mechanism has a function of moving the beam spot in a direction intersecting the longitudinal direction of the beam spot, and

> the control device further performs a step operation of shifting the beam spot in a direction intersecting the longitudinal direction of the beam spot with respect to the annealed target when one sweep operation is completed, and performs the annealing by repeating the sweep operation and the step operation.

3. The annealing device according to claim 1 or 2, wherein the control device controls the laser light source to set a repetition frequency of a pulse of the pulsed laser beam to 100 kHz or more during the sweep operation.

4. An annealing method for causing a pulsed laser beam to be incident on a surface of an annealed target (60) and performing annealing while moving a beam spot (39),

> wherein the beam spot has an elongated shape, and the annealing method comprises performing the annealing by performing a sweep operation of moving the beam spot in a longitudinal direction of the beam spot (S1), **characterized in that** an aspect ratio of the shaped elongated beam spot (39) is within a range of 1.5 to 2.5.

5. The annealing method according to claim 4, comprising performing a step operation of shifting the beam spot in a direction intersecting the longitudinal direction of the beam spot with respect to the annealed target when one sweep operation is completed (S2), and performing the annealing by repeating the sweep operation and the step operation (S3).

6. The annealing method according to claim 4 or 5, wherein during the sweep operation, a repetition frequency of a pulse of the pulsed laser beam incident on the annealed target is 100 kHz or more.

**Patentansprüche**

1. Glühvorrichtung, umfassend:

> eine Laserlichtquelle (10), die einen gepulsten Laserstrahl ausgibt;
> ein optisches Strahlformungselement (12), das einen Strahlfleck (39) des gepulsten Laserstrahls, der von der Laserlichtquelle ausgegeben wird, auf einer Fläche eines geglühten Targets (60) in eine längliche Form geformt wird,

> einen Bewegungsmechanismus (20), der den gepulsten Laserstrahl abtastet und den Strahlfleck in einer Längsrichtung des Strahlflecks bewegt; und
> eine Steuervorrichtung (40), die die Laserlichtquelle und den Bewegungsmechanismus steuert,
> wobei die Steuervorrichtung ein Glühen durchführt, indem sie eine Sweep-Operation durchführt, bei dem der Strahlfleck in der Längsrichtung des Strahlflecks in Bezug auf das geglühte Target bewegt wird, während der gepulste Laserstrahl veranlasst wird auf das geglühte Target aufzutreffen, **dadurch gekennzeichnet, dass** ein Seitenverhältnis des geformten länglichen Strahlflecks (39) innerhalb eines Bereichs von 1,5 bis 2,5 liegt.

2. Glühvorrichtung gemäß Anspruch 1, wobei der Bewegungsmechanismus eine Funktion aufweist, den Strahlfleck in einer Richtung zu bewegen, die die Längsrichtung des Strahlflecks schneidet, und

> die Steuervorrichtung ferner einen Schrittvorgang zum Verschieben des Strahlflecks in einer Richtung, die die Längsrichtung des Strahlflecks schneidet, in Bezug auf das geglühte Target durchführt, wenn eine Sweep-Operation abgeschlossen ist, und das Glühen durch Wiederholen der Sweep-Operation und des Schrittvorgangs durchführt.

3. Glühvorrichtung gemäß Anspruch 1 oder 2, wobei die Steuervorrichtung die Laserlichtquelle so steuert, dass die Wiederholungsfrequenz eines Pulses des gepulsten Laserstrahls während der Sweep-Operation auf 100 kHz oder mehr eingestellt wird.

4. Glühverfahren, um einen gepulsten Laserstrahl auf eine Oberfläche eines geglühten Targets (60) auftreffen zu lassen und Glühen durchzuführen, während ein Strahlfleck (39) bewegt wird,

> wobei der Strahlfleck eine längliche Form aufweist, und
> das Glühverfahren das Durchführen des Glühens durch Durchführen einer Sweep-Operation des Bewegens des Strahlflecks in einer Längsrichtung des Strahlflecks (S1) umfasst, **dadurch gekennzeichnet, dass** ein Seitenverhältnis des geformten Strahlflecks (39) innerhalb eines Bereichs von 1,5 bis 2,5 liegt.

5. Glühverfahren gemäß Anspruch 4, umfassend Durchführen eines Schrittvorgangs des Verschiebens des Strahlflecks in einer Richtung, die die Längsrichtung des Strahlflecks in Bezug auf das geglühte Target schneidet, wenn eine Sweep-Operation abgeschlossen ist (S2), und
Durchführen des Glühens durch Wiederholen der Sweep-Operation und des Schrittvorgangs (S3).

6. Glühverfahren gemäß Anspruch 4 oder 5, wobei während der Sweep-Operation die Wiederholungsfrequenz eines Pulses des gepulsten Laserstrahls, der auf das geglühte Target einfällt, 100 kHz oder mehr beträgt.

**Revendications**

1. Dispositif de recuit, comprenant :

une source de lumière laser (10) qui délivre un faisceau laser pulsé ;
un élément optique de mise en forme de faisceau (12) qui met en forme un point de faisceau (39) du faisceau laser pulsé délivré depuis la source de lumière laser sur une surface d'une cible recuite (60) dans une forme allongée ;
un mécanisme de déplacement (20) qui balaye le faisceau laser pulsé et déplace le point de faisceau dans une direction longitudinale du point de faisceau ; et
un dispositif de commande (40) qui commande la source de lumière laser et le mécanisme de déplacement,
dans lequel le dispositif de commande réalise un recuit par la réalisation d'une opération de balayage consistant à déplacer le point de faisceau dans la direction longitudinale du point de faisceau par rapport à la cible recuite tout en amenant le faisceau laser pulsé à être incident sur la cible recuite, **caractérisé en ce qu'**un rapport d'aspect du point de faisceau allongé mis en forme (39) est dans une plage de 1,5 à 2,5.

2. Dispositif de recuit selon la revendication 1, dans lequel le mécanisme de déplacement présente une fonction de déplacement du point de faisceau dans une direction en intersection avec la direction longitudinale du point de faisceau, et

le dispositif de commande en outre
réalise une opération de pas consistant à décaler le point de faisceau dans une direction en intersection avec la direction longitudinale du point de faisceau par rapport à la cible recuite lorsqu'une opération de balayage est terminée, et
réalise le recuit par la répétition de l'opération de balayage et de l'opération de pas.

3. Dispositif de recuit selon la revendication 1 ou 2, dans lequel le dispositif de commande commande la source de lumière laser pour régler une fréquence de répétition d'une impulsion du faisceau laser pulsé à 100 kHz ou plus pendant l'opération de balayage.

4. Procédé de recuit pour amener un faisceau laser pulsé à être incident sur une surface d'une cible recuite (60) et réaliser un recuit tout en déplaçant un point de faisceau (39),

dans lequel le point de faisceau présente une forme allongée, et
le procédé de recuit comprend la réalisation du recuit par la réalisation d'une opération de balayage consistant à déplacer le point de faisceau dans une direction longitudinale du point de faisceau (S1), **caractérisé en ce qu'**un rapport d'aspect du point de faisceau allongé mis en forme (39) est dans une plage de 1,5 à 2,5.

5. Procédé de recuit selon la revendication 4, comprenant la réalisation d'une opération de pas consistant à décaler le point de faisceau dans une direction en intersection avec la direction longitudinale du point de faisceau par rapport à la cible recuite lorsqu'une opération de balayage est terminée (S2), et
la réalisation du recuit par la répétition de l'opération de balayage et de l'opération de pas (S3).

6. Procédé de recuit selon la revendication 4 ou 5, dans lequel, pendant l'opération de balayage, une fréquence de répétition d'une impulsion du faisceau laser pulsé incident sur la cible recuite est 100 kHz ou plus.

FIG. 1

FIG. 2

FIG. 3

FIG. 4

FIG. 5A

FIG. 5B

Start

Execute the sweep operation of moving the beam
spot in the longitudinal direction of the beam spot
while causing the pulsed laser beam to be
incident on the surface of the annealed target — S1

Execute the step operation of shifting the
beam spot in the direction intersecting the
longitudinal direction of the beam spot — S2

Is annealing completed? — S3

End

# FIG. 6

FIG. 7A

FIG. 7B

FIG. 8

EP 4 123 685 B1

FIG. 9

18

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020202242 A

- CN 112864040